# EUROPEAN PATENT APPLICATION

(11) **EP 4 029 919 A2**
(43) Date of publication of application: **20.07.2022**
(21) Application number: 21211776.6
(22) Date of filing: 01.12.2021
(51) Int. Cl.: C09J 7/38, H01L 21/683

(54) **PRESSURE-SENSITIVE ADHESIVE SHEET FOR PROTECTING SEMICONDUCTOR ELEMENT**

(30) Priority: 15.01.2021 JP 2021005037
(71) Applicant: Nitto Denko Corporation, Ibaraki-shi, Osaka 567-8680 (JP)
(72) Inventor: Ueno, Taiki, Ibaraki-shi, Osaka (JP); Mizuno, Kouji, Ibaraki-shi, Osaka (JP); Tanaka, Shunpei, Ibaraki-shi, Osaka (JP); Hayashi, Miki, Ibaraki-shi, Osaka (JP)
(74) Representative: Grünecker Patent- und Rechtsanwälte PartG mbB

(57) **Abstract**

Provided is a pressure-sensitive adhesive sheet for protecting a semiconductor element that appropriately protects a semiconductor wafer without reducing a yield. The pressure-sensitive adhesive sheet for protecting a semiconductor element includes: a pressure-sensitive adhesive layer; and a base material. The pressure-sensitive adhesive layer has a surface resistivity of 1.0×10¹¹ Ω/□ or less. After the pressure-sensitive adhesive layer of the pressure-sensitive adhesive sheet for protecting a semiconductor element and a silicon wafer have been bonded to each other, and have been left at rest at 50°C for 24 hours, and the pressure-sensitive adhesive sheet for protecting a semiconductor element has been peeled, a halogen element ratio with respect to a total element content of a surface of the silicon wafer bonded to the pressure-sensitive adhesive layer is 0.3 atomic% or less.

## Description

### BACKGROUND OF THE INVENTION

This application claims priority under 35 U.S.C Section 119 to Japanese Patent Application No. 2021-005037 filed on January 15, 2021 which are herein incorporated by reference.

### 1. Field of the Invention

The present invention relates to a pressure-sensitive adhesive sheet for protecting a semiconductor element, and more specifically, to a pressure-sensitive adhesive sheet for protecting a semiconductor element to be used when a singulated semiconductor element is conveyed to a mounting process.

### 2. Description of the Related Art

A semiconductor element is produced by subjecting a silicon wafer to a backgrinding process and a dicing process. The semiconductor element that has passed through those processes is reduced in handleability, and hence may be conveyed to a semiconductor element-mounting process with a conveying pressure-sensitive adhesive sheet for protecting a semiconductor element. The semiconductor element that has been conveyed with the conveying pressure-sensitive adhesive sheet for protecting a semiconductor element is picked up from the pressure-sensitive adhesive sheet for protecting a semiconductor element, and is subjected to the mounting process. There is a problem in that when the semiconductor element is picked up from the pressure-sensitive adhesive sheet for protecting a semiconductor element, peeling electrification occurs to electrostatically break the semiconductor element, thereby reducing its yield. Accordingly, in the semiconductor element-mounting process, there has been a growing demand for a pressure-sensitive adhesive sheet having an antistatic property.

It has been known that antistatic performance is imparted to a pressure-sensitive adhesive sheet to be used in a semiconductor-processing process with an antistatic agent (e.g., Japanese Patent Application Laid-open No. 2020-174201 and WO 2018/003893 A1). However, there may occur a problem in that a halogen element derived from the antistatic agent in the pressure-sensitive adhesive layer of the sheet migrates to the surface of a semiconductor element. The halogen element that has migrated to the semiconductor element may corrode the semiconductor element. In addition, when a surfactant is used as the antistatic agent, the surfactant may be segregated on the surface of the pressure-sensitive adhesive layer to contaminate the semiconductor element. Accordingly, there has been required a conveying pressure-sensitive adhesive sheet for protecting a semiconductor element, which can appropriately protect the semiconductor element in its conveying process, and prevent a reduction in yield of the semiconductor element due to the electrostatic breakdown of the semiconductor element and the contamination of the semiconductor element.

### SUMMARY OF THE INVENTION

The present invention has been made to solve the problems of the related art, and an object of the present invention is to provide a pressure-sensitive adhesive sheet for protecting a semiconductor element that appropriately protects a semiconductor wafer without reducing a yield.

According to at least one embodiment of the present invention, there is provided a pressure-sensitive adhesive sheet for protecting a semiconductor element, including: a pressure-sensitive adhesive layer; and a base material. The pressure-sensitive adhesive layer has a surface resistivity of 1.0×10¹¹ Ω/□ or less, and after the pressure-sensitive adhesive layer of the pressure-sensitive adhesive sheet for protecting a semiconductor element and a silicon wafer have been bonded to each other, and have been left at rest at 50°C for 24 hours, and the pressure-sensitive adhesive sheet for protecting a semiconductor element has been peeled, a halogen element ratio with respect to a total element content of a surface of the silicon wafer bonded to the pressure-sensitive adhesive layer is 0.3 atomic% or less.

In at least one embodiment of the present invention, the pressure-sensitive adhesive layer contains an antistatic agent.

In at least one embodiment of the present invention, a content ratio of the antistatic agent in a composition for forming the pressure-sensitive adhesive layer is from 2 wt% to 30 wt%.

In at least one embodiment of the present invention, the antistatic agent is at least one kind selected from the group consisting of: a non-halogen ionic liquid; a conductive polymer; and a conductive carbon material.

In at least one embodiment of the present invention, the non-halogen ionic liquid is at least one kind selected from the group consisting of: an ammonium salt; an imidazole salt; a pyridinium salt; a phosphate; and a sulfonate.

In at least one embodiment of the present invention, the conductive polymer is at least one kind selected from the group consisting of: poly(3,4-ethylenedioxythiophene) doped with poly(4-styrenesulfonic acid); and polythiophene.

In at least one embodiment of the present invention, the pressure-sensitive adhesive layer has a thickness of from 1 µm to 100 µm.

### BRIEF DESCRIPTION OF THE DRAWINGS

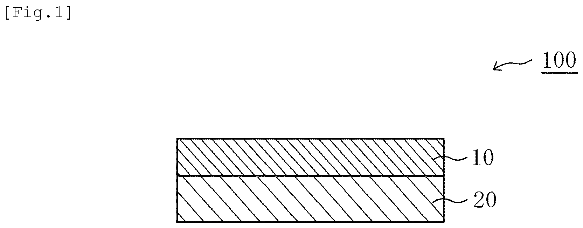

FIG. 1 is a schematic sectional view of a pressure-sensitive adhesive sheet for protecting a semiconductor element according to at least one embodiment of the present invention.

### DESCRIPTION OF THE EMBODIMENTS

### A. Overall Configuration of Pressure-sensitive Adhesive Sheet for protecting Semiconductor Element

FIG. 1 is a schematic sectional view of a pressure-sensitive adhesive sheet for protecting a semiconductor element (hereinafter also referred to as "pressure-sensitive adhesive sheet for protection") according to at least one embodiment of the present invention. A pressure-sensitive adhesive sheet 100 for protection includes a base material 10 and a pressure-sensitive adhesive layer 20 arranged on one surface of the base material. In at least one embodiment of the present invention, the base material 10 is free of any undercoat layer. The pressure-sensitive adhesive sheet for protection according to at least one embodiment of the present invention may have antistatic performance without including any undercoat layer. The pressure-sensitive adhesive sheet for protection may include any appropriate other layer (not shown). For example, any appropriate layer may be formed between the base material and the pressure-sensitive adhesive layer. A separator may be arranged outside the pressure-sensitive adhesive layer for the purpose of protecting the pressure-sensitive adhesive layer until the pressure-sensitive adhesive sheet for protection is brought into use.

In at least one embodiment of the present invention, the surface resistivity of the pressure-sensitive adhesive layer is 1.0×10¹¹ Ω/□ or less. When the surface resistivity of the pressure-sensitive adhesive layer falls within the range, peeling electrification in a semiconductor element-mounting process is suppressed, and hence the electrostatic breakdown of a semiconductor element can be prevented. The surface resistivity of the pressure-sensitive adhesive layer is preferably from 1.0×10⁵ Ω/□ to 1.0×10¹¹ Ω/□, more preferably from 1.0×10⁸ Ω/□ to 1.0×10¹⁰ Ω/□. Herein, the surface resistivity of the pressure-sensitive adhesive layer refers to a surface resistivity measured by a method described in Examples to be described later.

In at least one embodiment of the present invention, after the pressure-sensitive adhesive layer of the pressure-sensitive adhesive sheet for protecting a semiconductor element has been bonded to a silicon wafer, the bonded product has been left at rest at 50°C for 24 hours, and the pressure-sensitive adhesive sheet for protecting a semiconductor element has been peeled, a halogen element ratio with respect to the total element content of the surface of the silicon wafer bonded to the pressure-sensitive adhesive layer is 0.3 atomic% or less. When the halogen element ratio with respect to the total element content of the surface of the silicon wafer bonded to the pressure-sensitive adhesive layer after the peeling of the pressure-sensitive adhesive sheet for protection falls within the range, the contamination of a semiconductor element by a halogen element derived from the pressure-sensitive adhesive layer can be prevented. The halogen element ratio with respect to the total element content is preferably from 0 atomic% to 0.2 atomic%, more preferably from 0 atomic% to 0.1 atomic%. The halogen element ratio with respect to the total element content of the surface of the silicon wafer bonded to the pressure-sensitive adhesive layer after the peeling of the pressure-sensitive adhesive sheet for protection may be 0 atomic%. Herein, the halogen element ratio with respect to the total element content of the surface of the silicon wafer bonded to the pressure-sensitive adhesive layer after the peeling of the pressure-sensitive adhesive sheet for protection refers to a value measured by a method described in Examples to be described later with an X-ray photoelectron spectrometer (XPS).

The thickness of the pressure-sensitive adhesive sheet for protection according to at least one embodiment of the present invention may be set to any appropriate thickness. For example, the thickness of the pressure-sensitive adhesive sheet for protection is preferably from 50 µm to 900 µm, more preferably from 60 µm to 800 µm, still more preferably from 70 µm to 200 µm. When the thickness falls within the ranges, the sheet can appropriately support a semiconductor wafer, and hence its handleability can be maintained. In addition, the conveyance of the wafer with an apparatus can be efficiently performed, and hence a reduction in yield can be prevented.

### B. Base Material

Any appropriate base material is used as the base material 10. In at least one embodiment of the present invention, the base material is free of any undercoat layer. The pressure-sensitive adhesive sheet for protection according to at least one embodiment of the present invention can exhibit antistatic performance without including any undercoat layer. The base material may be a single layer, or may be a laminate of two or more layers. When the base material is a laminate of two or more layers, the layers are used so that the total thickness of the base material may be the thickness of the base material to be described later.

The thickness of the base material is preferably from 50 µm to 200 µm, more preferably from 60 µm to 180 µm, still more preferably from 70 µm to 180 µm. When the thickness of the base material falls within the ranges, the sheet can appropriately support a semiconductor element, and hence the occurrence of its warping and/or deflection can be prevented.

The base material may be formed of any appropriate resin. Specific examples of the resin for forming the base material include polyester-based resins, such as polyethylene naphthalate (PEN), polybutylene terephthalate (PBT), and polybutylene naphthalate (PBN), polyolefin-based resins, such as an ethylene-vinyl acetate copolymer, an ethylene-methyl methacrylate copolymer, polyethylene, polypropylene, and an ethylene-propylene copolymer, polyvinyl alcohol, polyvinylidene chloride, polyvinyl chloride, a vinyl chloride-vinyl acetate copolymer, polyvinyl acetate, polyamide, polyimide, celluloses, a fluorine-based resin, polyether, polystyrene-based resins, such as polystyrene, polycarbonate, polyether sulfone, and polyetheretherketone. Of those, polyolefin-based resins, such as an ethylene-vinyl acetate copolymer, polyethylene, polypropylene, and an ethylene-propylene copolymer, are preferably used.

The base material may further include another component to the extent that the effects of the present invention are not inhibited. Examples of the other component include an antioxidant, a UV absorber, a light stabilizer, and an antistatic agent. With regard to the kind and usage amount of the other component, the other component may be used in any appropriate amount in accordance with purposes.

### C. Pressure-sensitive Adhesive Layer

The pressure-sensitive adhesive layer **20** preferably contains an antistatic agent. Even when the pressure-sensitive adhesive layer contains the antistatic agent, the pressure-sensitive adhesive sheet for protection according to at least one embodiment of the present invention can prevent the contamination of a semiconductor element by a halogen element. The pressure-sensitive adhesive layer **20** is formed by using any appropriate composition for forming a pressure-sensitive adhesive layer (hereinafter also referred to as "pressure-sensitive adhesive layer-forming composition"). In at least one embodiment of the present invention, the pressure-sensitive adhesive layer-forming composition contains a pressure-sensitive adhesive and the antistatic agent.

In at least one embodiment of the present invention, the contents of a halogen element and a metal ion in the pressure-sensitive adhesive layer-forming composition are preferably as small as possible. When the pressure-sensitive adhesive layer-forming composition having small contents of the halogen element and the metal ion is used, the contamination of a semiconductor element by a component in the pressure-sensitive adhesive layer can be prevented. The content of the halogen element in the pressure-sensitive adhesive layer-forming composition is, for example, 1,000 ppm or less, preferably 500 ppm or less. In addition, the content of the metal ion in the pressure-sensitive adhesive layer-forming composition is, for example, 1,000 ppm or less, preferably 10 ppm or less. The contents of the halogen element and the metal ion in the pressure-sensitive adhesive layer-forming composition may each be measured by any appropriate method. For example, the content of the metal ion may be measured by using any one of inductively coupled plasma (ICP) spectroscopy and X-ray photoelectron spectroscopy (XPS), and the content of the halogen element in the pressure-sensitive adhesive layer-forming composition may be measured by using the X-ray photoelectron spectroscopy (XPS).

### C-1. Pressure-sensitive Adhesive

Any appropriate pressure-sensitive adhesive may be used as the pressure-sensitive adhesive. Examples of the pressure-sensitive adhesive include pressure-sensitive adhesives each containing, as a base polymer (pressure-sensitive resin), an acrylic resin, a silicone-based resin, a vinyl alkyl ether-based resin, a polyester-based resin, a polyamide-based resin, a urethane-based resin, or the like. Of those, an acrylic resin is preferably used because its pressure-sensitive adhesive strength can be easily adjusted, and its weatherability is excellent.

Any appropriate resin may be used as the acrylic resin. For example, an acrylic resin formed by using one kind or two or more kinds of (meth) acrylic acid alkyl esters as monomer components is used. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms is preferably used. Herein, the "(meth)acryl" refers to acryl and/or methacryl.

The acrylic resin may contain a unit corresponding to any other monomer component copolymerizable with the (meth) acrylic acid alkyl ester, as required, for the purpose of modification of cohesive strength, heat resistance, cross-linkability, or the like. Examples of such monomer component include: carboxyl group-containing monomers, such as acrylic acid, methacrylic acid, carboxyethyl acrylate, carboxypentyl acrylate, itaconic acid, maleic acid, fumaric acid, and crotonic acid; acid anhydride monomers, such as maleic anhydride and itaconic anhydride; hydroxyl group-containing monomers, such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfonic acid group-containing monomers, such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; (N-substituted) amide-based monomers, such as (meth)acrylamide, N,N-dimethyl(meth)acrylamide, N-butyl(meth)acrylamide, N-methylol (meth)acrylamide, and N-methylolpropane (meth)acrylamide; aminoalkyl (meth)acrylate-based monomers, such as aminoethyl (meth)acrylate, N,N-dimethylaminoethyl (meth)acrylate, and t-butylaminoethyl (meth)acrylate; alkoxyalkyl (meth)acrylate-based monomers, such as methoxyethyl (meth)acrylate and ethoxyethyl (meth)acrylate; maleimide-based monomers, such as N-cyclohexylmaleimide, N-isopropylmaleimide, N-laurylmaleimide, and N-phenylmaleimide; itaconimide-based monomers, such as N-methyl itaconimide, N-ethyl itaconimide, N-butyl itaconimide, N-octyl itaconimide, N-2-ethylhexyl itaconimide, N-cyclohexyl itaconimide, and N-lauryl itaconimide; succinimide-based monomers, such as N-(meth)acryloyloxymethylene succinimide, N-(meth)acryloyl-6-oxyhexamethylene succinimide, and N-(meth)acryloyl-8-oxyoctamethylene succinimide; vinyl-based monomers, such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic acid amides, styrene, α-methylstyrene, and N-vinylcaprolactam; cyanoacrylate monomers, such as acrylonitrile and methacrylonitrile; epoxy group-containing acrylic monomers, such as glycidyl (meth)acrylate; glycol-based acrylic ester monomers, such as polyethylene glycol (meth)acrylate, polypropylene glycol (meth)acrylate, methoxyethylene glycol (meth)acrylate, and methoxypolypropylene glycol (meth)acrylate; acrylic ester-based monomers each having, for example, a heterocycle or a silicon atom, such as tetrahydrofurfuryl (meth)acrylate and silicone (meth)acrylate; polyfunctional monomers, such as hexanediol di(meth)acrylate, (poly)ethylene glycol di(meth) acrylate, (poly) propylene glycol di(meth) acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, and urethane acrylate; olefin-based monomers, such as isoprene, butadiene, and isobutylene; and vinyl ether-based monomers, such as vinyl ether. Those monomer components may be used alone or in combination thereof.

In at least one embodiment of the present invention, the above-mentioned base polymer is preferably free of any halogen atom in its polymer skeleton. When the base polymer free of any halogen atom in its polymer skeleton is used, the contamination of a semiconductor element by a halogen in the pressure-sensitive adhesive sheet for protection can be prevented.

The base polymer may be obtained through the polymerization of the above-mentioned monomer component by any appropriate method. Examples of a method for the polymerization include solution polymerization, emulsion polymerization, bulk polymerization, and suspension polymerization. The method of polymerizing the base polymer may be selected in accordance with, for example, the antistatic agent to be used.

Any appropriate solvent may be used as a solvent to be used in the polymerization of the base polymer. In at least one embodiment of the present invention, a solvent having compatibility with the antistatic agent may be used as the solvent to be used in the polymerization.

### C-2. Antistatic Agent

Any appropriate antistatic agent may be used as the antistatic agent. The antistatic agent is preferably free of any halogen element. Specific examples thereof include a compound free of any halogen atom in its skeleton and an antistatic agent free of any halogen element as an impurity. At least one kind selected from the group consisting of: a non-halogen ionic liquid; a conductive polymer; and a conductive carbon material may be preferably used as the antistatic agent.

The antistatic agent may be used at any appropriate content. For example, the content of the antistatic agent in the composition for forming a pressure-sensitive adhesive layer (pressure-sensitive adhesive layer-forming composition) is preferably from 2 wt% to 30 wt%, more preferably from 3 wt% to 30 wt%. When the content of the antistatic agent in the pressure-sensitive adhesive layer-forming composition falls within the ranges, peeling electrification at the time of the pick-up of a semiconductor element is suppressed, and hence the electrostatic breakdown of the semiconductor element can be prevented.

### C-2-1. Non-halogen Ionic Liquid

In at least one embodiment of the present invention, the non-halogen ionic liquid may be suitably used as the antistatic agent. The ionic liquid refers to a salt that is a liquid at normal temperature. The non-halogen ionic liquid, that is, an ionic liquid whose anion and cation are each free of any halogen atom is suitably used as the antistatic agent. The non-halogen ionic liquids may be used alone or in combination thereof.

A cation free of any halogen atom in its skeleton may be used as the cation of the non-halogen ionic liquid. Examples thereof include organic cations represented by the following general formulae (A) to (E).

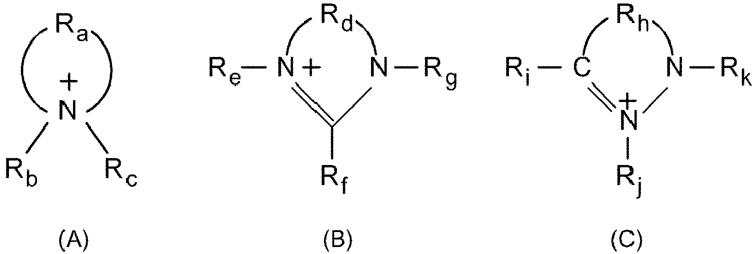

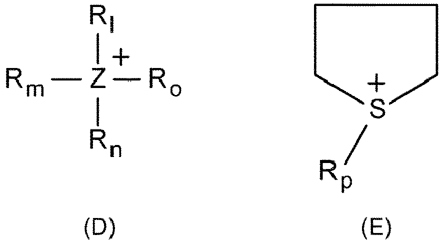

Here, in the formula (A), Ra represents a hydrocarbon group having 4 to 20 carbon atoms, or a functional group containing a heteroatom except a halogen atom, and Rb and Rc may be identical to or different from each other, and each represent a hydrogen atom, a hydrocarbon group having 1 to 16 carbon atoms, or a functional group containing a heteroatom except a halogen atom, provided that when a nitrogen atom contains a double bond, Rc is absent.

In the formula (B), Rd represents a hydrocarbon group having 2 to 20 carbon atoms, or a functional group containing a heteroatom except a halogen atom, and Re, Rf, and Rg may be identical to or different from each other, and each represent a hydrogen atom, a hydrocarbon group having 1 to 16 carbon atoms, or a functional group containing a heteroatom except a halogen atom.

In the formula (C), Rh represents a hydrocarbon group having 2 to 20 carbon atoms, or a functional group containing a heteroatom except a halogen atom, and Ri, Rj, and Rk may be identical to or different from each other, and each represent a hydrogen atom, a hydrocarbon group having 1 to 16 carbon atoms, or a functional group containing a heteroatom except a halogen atom.

In the formula (D), Z represents a nitrogen atom, a sulfur atom, or a phosphorus atom, and Rl, Rm, Rn, and Ro may be identical to or different from each other, and each represent a hydrocarbon group having 1 to 20 carbon atoms, or a functional group containing a heteroatom except a halogen atom, provided that when Z represents a sulfur atom, Ro is absent.

In the formula (E), Rp represents a hydrocarbon group having 1 to 18 carbon atoms, or a functional group containing a heteroatom except a halogen atom.

Examples of the cation represented by the formula (A) include a pyridinium cation, a pyrrolidinium cation, a piperidinium cation, a cation having a pyrroline skeleton, and a cation having a pyrrole skeleton. Examples of the cation represented by the formula (B) include an imidazolinium cation, a tetrahydropyrimidinium cation, and a dihydropyrimidinium cation. Examples of the cation represented by the formula (C) include a pyrazolium cation and a pyrazolinium cation. An example of the cation represented by the formula (D) is a cation in which Rl, Rm, Rn, and Ro are identical to or different from each other, and each represent an alkyl group having 1 to 20 carbon atoms. Specific examples of the cation include a tetraalkylammonium cation, a trialkylsulfonium cation, and a tetraalkylphosphonium cation. An example of the cation represented by the formula (E) is a sulfonium cation in which Rp represents any one of the alkyl groups each having 1 to 18 carbon atoms. Details about such cations are described in, for example, Japanese Patent Application Laid-open No. 2020-125436, the entire description of which is incorporated herein by reference.

An anion free of any halogen atom in its skeleton may be used as the anion. Examples thereof include organic anions, such as a carboxylic acid-based anion, an N-acyl amino acid ion, an acidic amino acid anion, a neutral amino acid anion, an alkyl sulfuric acid-based anion, and a phenol-based anion.

Specific examples of the carboxylic acid-based anion include an acetate ion, a decanoate ion, a 2-pyrrolidone-5-carboxylate ion, a formate ion, an α-lipoate ion, a lactate ion, a tartrate ion, a hippurate ion, and an N-methyl hippurate ion.

Specific examples of the N-acyl amino acid ion include an N-benzoylalanine ion, an N-acetylphenylalanine ion, an aspartate ion, a glycine ion, and an N-acetylglycine ion.

Specific examples of the acidic amino acid anion include an aspartate ion and a glutamate ion. Specific examples of the neutral amino acid anion include a glycine ion, an alanine ion, and a phenylalanine ion.

A specific example of the alkyl sulfuric acid-based anion is a methanesulfonate ion. Specific examples of the phenol-based anion include a phenol ion, a 2-methoxyphenol ion, and a 2,6-di-tert-butylphenol ion.

When the non-halogen ionic liquid is used as the antistatic agent, the content of the antistatic agent is preferably from 6 parts by weight to 50 parts by weight, more preferably from 6 parts by weight to 40 parts by weight, still more preferably from 6 parts by weight to 20 parts by weight with respect to 100 parts by weight of the base polymer. When the content of the non-halogen ionic liquid to be used as the antistatic agent falls within the ranges, peeling electrification at the time of the pick-up of a semiconductor element is suppressed, and hence the electrostatic breakdown of the semiconductor element can be prevented.

In at least one embodiment of the present invention, when the non-halogen ionic liquid is used as the antistatic agent, a polymer obtained by subjecting the monomer component to solution polymerization may be suitably used as the base polymer. When the base polymer obtained by the solution polymerization is used, the base polymer and the antistatic agent can be more uniformly mixed, and as a result, a pressure-sensitive adhesive layer excellent in pressure-sensitive adhesive performance and antistatic performance can be formed.

A solvent to be used in the solution polymerization only needs to be a solvent in which the non-halogen ionic liquid to be used is dissolved, and any appropriate solvent may be used. Examples thereof include ethyl acetate, toluene, and methyl ethyl ketone.

### C-2-2. Conductive Polymer

Any appropriate conductive polymer may be used as the conductive polymer. Examples thereof include poly(3,4-ethylenedioxythiophene) (PEDOT), polyaniline, polythiophene, and polydiacetylene. In addition, poly(3,4-ethylenedioxythiophene) doped with poly(4-styrenesulfonic acid) (PEDOT-PSS) may also be used. Of those, PEDOT-PSS and polythiophene are preferably used. Those conductive polymers may be used alone or in combination thereof.

When the conductive polymer is used as the antistatic agent, the content of the antistatic agent is preferably from 1 part by weight to 10 parts by weight, more preferably from 2 parts by weight to 8 parts by weight, still more preferably from 3 parts by weight to 7 parts by weight with respect to 100 parts by weight of the base polymer. When the content of the conductive polymer to be used as the antistatic agent falls within the ranges, peeling electrification at the time of the pick-up of a semiconductor element is suppressed, and hence the electrostatic breakdown of the semiconductor element can be prevented.

In at least one embodiment of the present invention, when the conductive polymer is used as the antistatic agent, a polymer obtained by subjecting the monomer component to emulsion polymerization may be suitably used as the base polymer. When the base polymer obtained by the emulsion polymerization is used, the base polymer and the conductive polymer serving as the antistatic agent can be more uniformly mixed. As a result, a pressure-sensitive adhesive layer excellent in pressure-sensitive adhesive performance and antistatic performance can be formed.

Any appropriate solvent may be used as a solvent to be used in the emulsion polymerization in accordance with the conductive polymer to be used. An example thereof is water.

### C-2-3. Conductive Carbon Material

Any appropriate conductive carbon material may be used as the conductive carbon material. Examples thereof include a carbon nanotube and graphene. Those conductive carbon materials may be used alone or in combination thereof.

When the conductive carbon material is used as the antistatic agent, the content of the antistatic agent is preferably from 1 part by weight to 10 parts by weight, more preferably from 2 parts by weight to 8 parts by weight, still more preferably from 3 parts by weight to 6 parts by weight with respect to 100 parts by weight of the base polymer. When the content of the conductive carbon material to be used as the antistatic agent falls within the ranges, peeling electrification at the time of the pick-up of a semiconductor element can be suppressed.

In at least one embodiment of the present invention, when the conductive carbon material is used as the antistatic agent, a polymer obtained by subjecting the monomer component to solution polymerization may be suitably used as the base polymer. When the base polymer obtained by the solution polymerization is used, the base polymer and the conductive carbon material serving as the antistatic agent can be more uniformly mixed. As a result, a pressure-sensitive adhesive layer excellent in pressure-sensitive adhesive performance and antistatic performance can be formed.

A solvent to be used in the solution polymerization only needs to be a solvent in which the conductive carbon material to be used is dispersible, and any appropriate solvent may be used. Examples thereof include ethyl acetate and toluene.

### C-3. Additive

The pressure-sensitive adhesive layer-forming composition may contain any appropriate additive. Examples of the additive include a cross-linking agent, a light peeling agent, a catalyst (e.g., a platinum catalyst or a zirconium catalyst), a tackifier, a plasticizer, a pigment, a dye, a filler, an age resistor, a UV absorber, a light stabilizer, a peeling modifier, a softener, a flame retardant, and a solvent.

The thickness of the pressure-sensitive adhesive layer may be set to any appropriate value. The thickness of the pressure-sensitive adhesive layer is preferably from 1 µm to 100 µm, more preferably from 1 µm to 20 µm, still more preferably from 1 µm to 10 µm. When the thickness of the pressure-sensitive adhesive layer falls within the ranges, the layer can exhibit sufficient pressure-sensitive adhesive strength to an adherend.

### D. Method of producing Pressure-sensitive Adhesive Sheet for protecting Semiconductor Element

The pressure-sensitive adhesive sheet for protecting a semiconductor element may be produced by any appropriate method. The sheet may be obtained by, for example, a method including: applying a pressure-sensitive adhesive solution (pressure-sensitive adhesive layer-forming composition) to the separator; drying the solution to form the pressure-sensitive adhesive layer on the separator; and then bonding the layer to the base material. In addition, the pressure-sensitive adhesive sheet for protecting a semiconductor element may be obtained by applying the pressure-sensitive adhesive layer-forming composition onto the base material and drying the composition. Various methods, such as bar coater coating, air knife coating, gravure coating, gravure reverse coating, reverse roll coating, lip coating, die coating, dip coating, offset printing, frexographic printing, and screen printing, may each be adopted as a coating method for the pressure-sensitive adhesive layer-forming composition. Any appropriate method may be adopted as a drying method.

### E. Application of Pressure-sensitive Adhesive Sheet for protecting Semiconductor Element

The pressure-sensitive adhesive sheet for protecting a semiconductor element may be suitably used when a semiconductor element is conveyed to a mounting process. As described above, the pressure-sensitive adhesive sheet for protecting a semiconductor element can prevent the contamination of the semiconductor element by the component derived from the pressure-sensitive adhesive layer. Further, the sheet can prevent the electrostatic breakdown of the semiconductor element due to peeling electrification occurring at the time of the pick-up of the semiconductor element. Accordingly, the sheet can prevent a reduction in yield in a semiconductor element production method.

### Examples

Now, the present invention is specifically described by way of Examples, but the present invention is not limited to these Examples. In addition, in Examples, "part (s)" and "%" are by weight unless otherwise stated.

### [Production Example 1]

### Preparation of Base Polymer 1 (HAOMA 75)

75 Parts of 2-ethylhexyl acrylate, 25 parts of N-acryloylmorpholine, 3 parts of acrylic acid, 0.2 part of 2,2'-azobisisobutyronitrile, 0.1 part of hydroxyethyl acrylate, and 200 parts of ethyl acetate were blended so that their total amount became 200 g, followed by their loading into a 500-milliliter three-necked flask-type reactor including a temperature gauge, a stirring machine, a nitrogen-introducing tube, and a reflux condenser. Next, the mixture was stirred while a nitrogen gas was introduced for about 1 hour to replace air in the reactor with nitrogen. After that, a temperature therein was set to 60°C, and polymerization was performed by holding the mixture under the state for about 6 hours. Thus, a polymer solution was obtained. The weight-average molecular weight of the polymer measured by gel permeation chromatography (GPC) was 1,200,000.

### [Production Example 2]

### Preparation of Base Polymer 2 (H-624)

An acrylic acid-methacrylic acid-based copolymer "RHEOCOAT H-624" (manufactured by Toray Coatex Co., Ltd., 64 parts of butyl acrylate, 33 parts of methyl methacrylate, and 3 parts of hydroxyethyl acrylate) was used as a base polymer (pressure-sensitive adhesive). The weight-average molecular weight of the polymer was 320,000.

### [Example 1]

100 Parts by weight of the base polymer 1, 4 parts by weight of a cross-linking agent (manufactured by Nippon Polyurethane Industry Co., Ltd., product name: "CORONATE L"), 2 parts by weight of a light peeling agent (manufactured by DKS Co., Ltd., product name: "EPAN 710"), and 7 parts by weight of an antistatic agent 1 (manufactured by Nippon Nyukazai Co., Ltd., product name: "AMINOION AS100," halogen-free ionic liquid) were mixed to prepare a pressure-sensitive adhesive layer-forming composition.

The resultant pressure-sensitive adhesive layer-forming composition was applied to a polyolefin base material of a three-layer structure (polyolefin/polypropylene/polyolefin, thickness: 100 µm) so that an entire thickness after its drying became 105 µm, followed by drying. Thus, a pressure-sensitive adhesive sheet for protecting a semiconductor element was obtained.

### [Example 2]

A pressure-sensitive adhesive sheet for protecting a semiconductor element was obtained in the same manner as in Example 1 except that the content of the antistatic agent 1 was set to 10 parts by weight.

### [Example 3]

A pressure-sensitive adhesive sheet for protecting a semiconductor element was obtained in the same manner as in Example 1 except that the content of the antistatic agent 1 was set to 30 parts by weight.

### [Example 4]

A pressure-sensitive adhesive sheet for protecting a semiconductor element was obtained in the same manner as in Example 1 except that: the base polymer 2 was used; the light peeling agent was not added; and 3 parts by weight of an antistatic agent 2 (manufactured by Chukyo Yushi Co., Ltd., product name: "W-337," conductive polymer (PEDOT-PSS)) was used instead of the antistatic agent 1.

### (Comparative Example 1)

A pressure-sensitive adhesive sheet for protecting a semiconductor element was obtained in the same manner as in Example 1 except that in Example 1, the content of the antistatic agent 1 was changed to 5 parts by weight.

### (Comparative Example 2)

A pressure-sensitive adhesive sheet for protecting a semiconductor element was obtained in the same manner as in Example 4 except that an antistatic agent 3 (manufactured by Japan Carlit Co., Ltd., product name: "CIL-312," halogen-containing ionic liquid) was used instead of the antistatic agent 2.

### (Comparative Example 3)

A pressure-sensitive adhesive sheet for protecting a semiconductor element was obtained in the same manner as in Comparative Example 2 except that the content of the antistatic agent 3 was set to 10 parts by weight.

### (Comparative Example 4)

A pressure-sensitive adhesive sheet for protecting a semiconductor element was obtained in the same manner as in Example 4 except that an antistatic agent 4 (manufactured by DKS Co., Ltd., product name: "ELEXCEL AS-110," halogen-containing ionic liquid) was used instead of the antistatic agent 2.

### (Comparative Example 5)

An attempt was made to produce a pressure-sensitive adhesive sheet for protecting a semiconductor element in the same manner as in Example 1 except that 3 parts by weight of the antistatic agent 2 was used instead of the antistatic agent 1. However, the base polymer and the antistatic agent could not be homogeneously mixed, and hence a pressure-sensitive adhesive layer could not be formed by using a pressure-sensitive adhesive layer-forming composition.

### <Evaluation>

The following evaluations were performed by using the pressure-sensitive adhesive sheets for protecting semiconductor elements obtained in Examples and Comparative Examples, and the pressure-sensitive adhesive layer-forming compositions. The results are shown in Table 1.

### 1. Surface Resistivity

The surface resistivity of a pressure-sensitive adhesive layer was measured in conformity with JIS K 6911. Specifically, a probe was pressed against the pressure-sensitive adhesive layer of each of the resultant pressure-sensitive adhesive sheets for protecting semiconductor elements, and a stable value after the lapse of 30 seconds from the pressing was read. The measurement was performed under the following measurement conditions.

### <Measurement Conditions>

Resistance meter: HIRESTA
Probe: URS
Temperature: 23°C±2°C
Humidity: 50%RH±5%RH

### 2. Halogen Element Ratio of Silicon Wafer Surface

The pressure-sensitive adhesive sheet for protecting a semiconductor element obtained in each of Examples and Comparative Examples was cut out into a strip shape having a width of 20 mm and a length of 50 mm with a box cutter to produce a sample piece. Under 23°C, the pressure-sensitive adhesive layer of the sample piece from which a separator had been peeled was brought into contact with a mirror-finished silicon wafer (manufactured by Shin-Etsu Semiconductor Co., Ltd., product name: "CZN<100>2.5-3.5," diameter: 4 inches), and a 2-kilogram roller was reciprocated once to bond the pressure-sensitive adhesive sheet for protecting a semiconductor element to the silicon wafer. After that, the bonded product was left at rest at no load under an atmosphere at 50°C for 24 hours. Next, the temperature of the sample obtained by bonding the pressure-sensitive adhesive sheet for protecting a semiconductor element and the silicon wafer to each other was returned to room temperature, and the pressure-sensitive adhesive sheet for protecting a semiconductor element was peeled from the silicon wafer. The surface of the silicon wafer bonded to the pressure-sensitive adhesive layer was subjected to wafer surface elemental analysis (qualitative analysis) with an XPS by wide scanning. Next, elements detected by the wide scanning were subjected to narrow analysis, and the content ratio of a halogen element with respect to the total element content of the surface was calculated. The measurement was performed under the following conditions.

### <Measurement Conditions>

XPS: Quantum 2000 manufactured by ULVAC-PHI, Inc.
X-ray source: Monochromatic Al Kα
X-ray setting: 200 µmϕ "15 kV, 30 W"
Photoelectron extraction angle: 45° with respect to the surface of the sample
Neutralization condition: Combined use of a neutralization gun and an Ar ion gun (neutralization mode)
Bonding rate: 3 mm/sec
Cutter temperature: 180°C
Cutting rate: 200 mm/sec
Cutter blade: Art Knife Replacement Blade XB10 (manufactured by Olfa Corporation)

### 3. Compatibility

The materials for each of the pressure-sensitive adhesive layer-forming compositions were mixed, and the state of the composition was visually observed. The composition in which the materials were uniformly mixed was evaluated as good (indicated by Symbol "○"), and the composition in which the materials were nonuniformly mixed or could not be mixed was evaluated as poor (indicated by Symbol "×").

**Table 1**

| | | | Example | | | | |
|---|---|---|---|---|---|---|---|
| | | | 1 | 2 | 3 | 4 | |
| Composition | Polymer | | 100 Parts of HAOMA 75 | | | 100 Parts of H-624 | |
| | | Cross-linking agent | 4 Parts of CORONATE L | | | | |
| | Light peeling agent | | 2 Parts of EPAN 710 | | | 0 | |
| | Antistatic agent | Kind | AMINOION | AS100 (halogen-free liquid) | ionic | W-337 (conductive polymer PEDOT-PSS) | |
| | | Number of parts | 7 | 10 | 30 | 3 | |
| Evaluation | Surface resistivity Ω/□ | | 7.23.E+10 | 4.57.E+09 | 2.00.E+09 | 9.77.E+07 | |
| | ΔF at time of bonding and peeling of wafer/atomic % | | 0.0 | 0.0 | 0.0 | 0.0 | |
| | Compatibility | | o | o | o | o | |
| | | | | | | | |

| | | | Comparative Example | | | | |
|---|---|---|---|---|---|---|---|
| | | | 1 | 2 | 3 | 4 | 5 |
| Composition | Polymer | | 100 Parts of HAOMA 75 | 100 Parts of H-624 | | | 100 Parts of HAOMA75 |
| | Cross-linking agent | | | 4 Parts of CORONATE L | | | |
| | Light peeling agent | | 2 Parts of EPAN 710 | 0 | | | 2 Parts of EPAN 710 |
| | Antistatic agent | Kind | AMINOION AS100 (halogen-fr ee ionic liquid) | CIL-312 (halogen-containing ionic liquid) | | AS-110 (halogen-co ntaining ionic liquid) | W-337 (conductive polymer PEDOT-PSS) |
| | | Number of parts | 5 | 3 | 10 | 3 | 3 |
| Evaluation | Surface resistivity Ω/□ | | 3.35E+11 | 2.36E+10 | 5.16.E+09 | 1.16.E+10 | - |
| | ΔF at time of of wafer bonding and peeling /atomic % | | 0.0 | 0.4 | 0. 6 | 0.7 | - |
| | Compatibility | | o | o | o | o | × |

The pressure-sensitive adhesive sheet for protecting a semiconductor element according to at least one embodiment of the present invention may be suitably used for protecting a semiconductor element in a semiconductor element-conveying process.

According to at least one embodiment of the present invention, there can be provided the pressure-sensitive adhesive sheet for protecting a semiconductor element that appropriately protects a semiconductor wafer without reducing a yield. The pressure-sensitive adhesive sheet for protecting a semiconductor element according to at least one embodiment of the present invention can prevent the contamination of a semiconductor element by the antistatic agent in the pressure-sensitive adhesive layer, and the electrostatic breakdown of the semiconductor element due to peeling electrification. Accordingly, the sheet can appropriately protect the semiconductor element in its conveying process, and prevent a reduction in yield thereof in its mounting process.

## Claims

1. A pressure-sensitive adhesive sheet for protecting a semiconductor element, comprising:
a pressure-sensitive adhesive layer; and
a base material,
wherein the pressure-sensitive adhesive layer has a surface resistivity of 1.0×10¹¹ Q/□ or less, and
wherein after the pressure-sensitive adhesive layer of the pressure-sensitive adhesive sheet for protecting a semiconductor element and a silicon wafer have been bonded to each other, and have been left at rest at 50°C for 24 hours, and the pressure-sensitive adhesive sheet for protecting a semiconductor element has been peeled, a halogen element ratio with respect to a total element content of a surface of the silicon wafer bonded to the pressure-sensitive adhesive layer is 0.3 atomic% or less.

2. The pressure-sensitive adhesive sheet for protecting a semiconductor element according to claim 1, wherein the pressure-sensitive adhesive layer contains an antistatic agent.

3. The pressure-sensitive adhesive sheet for protecting a semiconductor element according to claim 1 or 2, wherein a content ratio of the antistatic agent in a composition for forming the pressure-sensitive adhesive layer is from 2 wt% to 30 wt%.

4. The pressure-sensitive adhesive sheet for protecting a semiconductor element according to any one of claims 1 to 3, wherein the antistatic agent is at least one kind selected from the group consisting of: a non-halogen ionic liquid; a conductive polymer; and a conductive carbon material.

5. The pressure-sensitive adhesive sheet for protecting a semiconductor element according to claim 4, wherein the non-halogen ionic liquid is at least one kind selected from the group consisting of: an ammonium salt; an imidazole salt; a pyridinium salt; a phosphate; and a sulfonate.

6. The pressure-sensitive adhesive sheet for protecting a semiconductor element according to claim 4, wherein the conductive polymer is at least one kind selected from the group consisting of: poly(3,4-ethylenedioxythiophene) doped with poly(4-styrenesulfonic acid); and polythiophene.

7. The pressure-sensitive adhesive sheet for protecting a semiconductor element according to any one of claims 1 to 6, wherein the pressure-sensitive adhesive layer has a thickness of from 1 µm to 100 µm.
